# EUROPÄISCHE PATENTSCHRIFT

(11) **EP 1 799 392 B1**
(45) Veröffentlichungstag und Bekanntmachung des Hinweises auf die Patenterteilung: **05.08.2009**
(21) Anmeldenummer: 05794084.3
(22) Anmeldetag: 30.09.2005
(51) Int. Cl.: B23K 26/06, B23K 26/073, H01S 5/40

(54) **LASERANORDNUNG**
LASER ARRANGEMENT
CONFIGURATION DE LASER

(30) Priorität: 06.10.2004 DE 102004048917; 27.11.2004 WO PCT/EP2004/013494; 04.02.2005 DE 102005005453
(43) Veröffentlichungstag der Anmeldung: 27.06.2007
(73) Patentinhaber: LIMO Patentverwaltung GmbH & Co. KG, 36419 Gerstengrund (DE)
(72) Erfinder: LISSOTSCHENKO, Vitalij, 58730 Fröndenberg (DE); MIKHAILOV, Aleksei, 44227 Dortmund (DE)
(74) Vertreter: Basfeld, Rainer
(86) Internationale Anmeldenummer: PCT/EP2005/010588
(87) Internationale Veröffentlichungsnummer: WO 2006/037566

(56) Entgegenhaltungen:
- WO-A-00/13839
- WO-A-01/26859
- WO-A-03/098758
- DE-A1- 10 062 453
- US-A- 4 681 394
- US-A- 4 826 269

## Beschreibung

Die vorliegende Erfindung betrifft eine Laseranordnung gemäß dem Oberbegriff des Anspruchs 1.

Die in der vorgenannten Anordnung erwähnte Mehrzahl von Laserlichtquellen kann nicht nur durch eine Mehrzahl von Lasern realisiert werden, sondern auch durch die von einem Laser ausgehende Laserstrahlung, die in mehrere Teilstrahlen aufgespalten wird. Beispielsweise können diese Teilstrahlen dann in unterschiedliche Lichtleitfasern eingekoppelt werden.

Es ist bekannt, Werkstücke mit einem Laserstrahl zu bearbeiten. Der Laserstrahl bildet einen Arbeitsbereich auf dem Werkstück aus, der durch einen bestimmten Energieeintrag definiert ist. Es ist weiterhin bekannt eine Anzahl von Laserlichtquellen in einer Reihe anzuordnen und deren Laserstrahlen gemeinsam auf ein Werkstück auszurichten. In diesem Fall ergibt sich bei paralleler Ausrichtung der Laserstrahlen ein Arbeitsbereich der durch die sich überschneidenden Laserstrahlen ausgebildet wird.

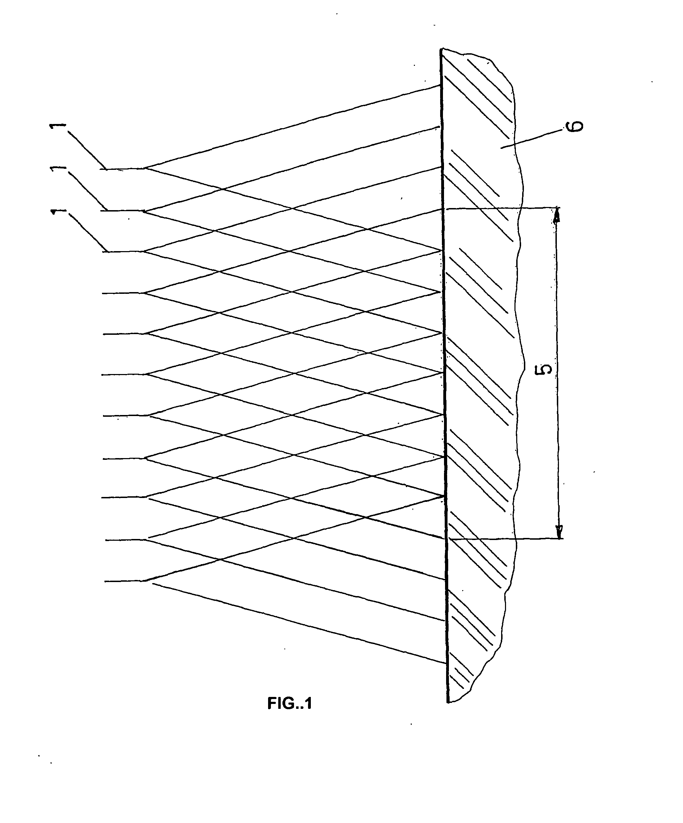

Bedingt durch die Auffächerung und Überschneidung der Laserstrahlen (angedeutet in Fig. 1) ergeben sich Randbereiche des linienförmigen Arbeitsbereichs, die eine geringere Energiedichte aufweisen, da sie lediglich von einer Laserlichtquelle erreicht werden und innere Bereiche höherer Energiedichte, da sie von zwei oder mehr Laserlichtquellen erreicht werden.

Für die Bearbeitung eines Werkstücks wird jedoch beispielsweise ein Arbeitsbereich gefordert, der eine minimale und vorgegebene Energieeinstrahlung und eine vorbestimmte räumliche Ausdehnung aufweist. Dementsprechend müssen entsprechend viele Laserlichtquellen in der zuvor beschrieben Weise angeordnet werden um die Anforderungen hinsichtlich Energieeinstrahlung und Ausdehnung zu erfüllen, wohingegen die Randbereiche, die beispielsweise nur von einer Laserlichtquelle erreicht werden können, ungenutzt bleiben, da der Energieeintrag hier zu gering ist.

Ein weiterer Nachteil bekannter Anordnungen ist die Tatsache, dass das Licht von einer Vielzahl von Laserlichtquellen nicht oder nur mit sehr großem Aufwand in den linienförmigen Arbeitsbereich einbringbar ist.

Aus der WO 00/13839 ist eine Laseranordnung der eingangs genannten Art bekannt, die eine Mehrzahl von Faserlasern aufweist. Diese Faserlaser sind beispielsweise in einer Reihe nebeneinander und/oder auf einem Kreisbogen angeordnet. Insbesondere sind mehrere Gruppen von Faserlasern vorgesehen, deren Licht durch wellenlängenselektive Strahlteiler miteinander gekoppelt wird. Dabei wird das Laserlicht einer Gruppe der Faserlaser unter einem Winkel von 90° reflektiert, wohingegen das Laserlicht einer anderen Gruppe von Faserlasern weitgehend ungehindert durch den Strahlteiler hindurch tritt.

Es ist die Aufgabe der vorliegenden Erfindung, eine Laseranordnung der eingangs genannten Art bereitzustellen, die durch einen höheren Wirkungsgrad gekennzeichnet ist und/oder das Licht einer Vielzahl von Laserlichtquellen in der Arbeitsebene zusammenfassen kann.

Dies wird durch Laseranordnung der eingangs genannten Art mit den kennzeichnenden Merkmalen des Anspruchs 1 gelöst.

Gemäß Anspruch 1 ist vorgesehen, dass die Laserlichtquellen einen linienförmigen Arbeitsbereich ausbilden können, wobei das mindestens eine Reflektionselement dazu geeignet ist, die von den äußeren Laserlichtquellen ausgehende Laserstrahlung in den Arbeitsbereich zu reflektieren. Durch eine derartige Anordnung der Laserlichtquellen und des mindestens einen Reflektionselements wird es ermöglicht, die ansonsten ungenutzte Energie der im Randbereich angeordneten Laserlichtquellen für den vorbestimmten Arbeitsbereich nutzbar zu machen, wodurch ein höherer Wirkungsgrad der gesamten Laseranordnung erzielbar ist. Auch kann durch die Umlenkung eine homogenere Energieverteilung über den Arbeitsbereich erreicht werden, da gezielt Bereiche mit geringerer Energiedichte zusätzlich ausgeleuchtet werden können.

Zusätzlich ist gemäß Anspruch 1 vorgesehen, dass das mindestens eine Reflektionselement flächig ausgestaltet ist und dass die Reihe der Laserlichtquellen in etwa orthogonal zu dem mindestens einen Reflektionselement ausgerichtet ist. Durch eine derartige Ausgestaltung und Anordnung von Reflektionselement und Laserlichtquellen lassen sich besonders gute Ergebnisse erzielen. Insbesondere eignet sich eine derartige Laseranordnung für den Einsatz in der industriellen Fertigung.

In diesem Zusammenhang kann weiterhin vorteilhafterweise vorgesehen sein, dass ein erstes Reflektionselement und ein zweites Reflektionselement vorgesehen ist, wobei sich die Reflektionselemente in etwa zwischen den Laserlichtquellen und dem Werkstück erstrecken. Auch diese Anordnung eignet sich in besonders vorteilhafter Weise für den industriellen Einsatz.

Zur Verbesserung der Homogenität der Energieverteilung im Arbeitsbereich kann vorteilhafterweise vorgesehen sein, dass eine Linseneinrichtung zwischen den Laserlichtquellen und dem Werkstück angeordnet ist, die zur Kollimation oder Fokussierung der von den Laserlichtquellen ausgesandten Laserstrahlen hinsichtlich einer Richtung, insbesondere hinsichtlich einer Richtung senkrecht zur mittleren Ausbreitungsrichtung der Laserstrahlen, geeignet ist. Weil die Laserstrahlen nur hinsichtlich einer Querrichtung, nicht aber in der dazu senkrechten Querrichtung kollimiert oder fokussiert werden, wird es ermöglicht, vorzugsweise stark elliptische und weitgehend überlappende Laserlichtkegel zu erzeugen, die sich zu dem gewünschten linienförmigen Arbeitsbereich ergänzen.

Hierzu kann in vorteilhafter Weise vorgesehen sein, dass es sich bei der Linseneinrichtung um mindestens eine Zylinderlinse handelt. Es kann auch vorgesehen sein, dass es sich bei der Linseneinrichtung um eine Mehrzahl von Zylinderlinsen handelt, die vorzugsweise einen Winkel ungleich 0° und ungleich 180°, insbesondere einen Winkel zwischen 140° und 160°, miteinander einschließen.

Auch kann zur Einbringung einer höheren Lichtleistung in den Arbeitsbereich vorteilhafterweise vorgesehen sein, dass die Laserlichtquellen in parallelen Reihen angeordnet sind

In einer vorteilhaften Ausgestaltung der vorliegenden Erfindung kann vorgesehen sein, dass der Abstand zwischen der Linseneinrichtung und dem Werkstück in etwa 50 cm beträgt. Hierdurch lassen sich Arbeitsbereiche mit besonders homogener Energiedichte ausgestalten.

Es kann vorgesehen sein, dass einige oder sämtliche der Laserlichtquellen auf einem Kreisbogen angeordnet sind. Dadurch lassen sich bei entsprechend großem Radius des Kreisbogens sehr viele, insbesondere beliebig viele Laserlichtquellen vorsehen, deren Licht in der Arbeitsebene in einem linienförmigen Arbeitsbereich zusammengeführt werden.

Dabei kann vorgesehen sein, dass die von den auf dem Kreisbogen angeordneten Laserlichtquellen ausgehende Laserstrahlung zumindest teilweise in einen Fokusbereich, der insbesondere im Wesentlichen punktförmig ist, fokussiert wird.

Weiterhin kann vorgesehen sein, dass der Kreisbogen um einen Mittelpunkt angeordnet ist, der im Wesentlichen dem, insbesondere punktförmigen, Fokusbereich entspricht.

Vorzugsweise kann weiterhin vorgesehen sein, dass es sich bei der Laserlichtquelle um einen Halbleiterlaser oder um eine Lichtleitfaser handelt, die vorzugsweise von mindestens einem Halbleiterlaser gespeist wird.

Zum Schutz der Laseranordnung kann vorteilhafterweise vorgesehen sein, dass eine laserlichtdurchlässige Platte zwischen der Linseneinrichtung und dem Werkstück vorgesehen ist.

Es kann vorgesehen sein, dass die Laserstrahlung hinter dem Fokusbereich, in den die von den auf dem Kreisbogen angeordneten Laserlichtquellen ausgehende Laserstrahlung fokussiert wird, auf die Zylinderlinse oder die Mehrzahl von Zylinderlinsen trifft.

Dabei kann vorgesehen sein, dass zwischen dem Fokusbereich und der Zylinderlinse oder der Mehrzahl von Zylinderlinsen eine weitere Linse, insbesondere eine weitere Zylinderlinse vorgesehen ist.

Dabei kann vorgesehen sein, dass in Ausbreitungsrichtung der Laserstrahlung hinter den Reflexionselementen eine Abbildungsoptik zur Abbildung der Laserstrahlung auf das Werkstück vorgesehen ist. Durch eine derartige Maßnahme kann ein vergleichsweise großer Abstand des Arbeitsbereichs von den unter Umständen sehr großen und damit unhandlichen Reflexionselementen gewählt werden.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine schematisch Darstellung einer Laseranordnung gemäß dem Stand der Technik;
- Fig. 2: eine schematische Darstellung einer erfindungsgemäßen Laseranordnung in einer Draufsicht;
- Fig. 3: eine schematische Darstellung einer erfindungsgemäßen Laseranordnung in einer seitlichen Ansicht;

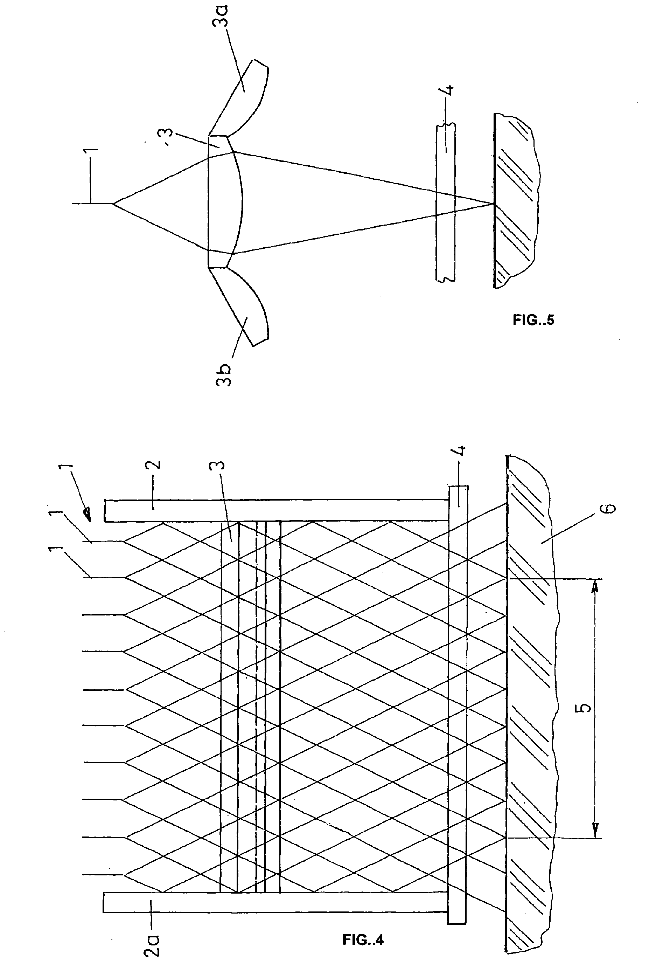

- Fig. 4: eine schematische Darstellung einer weiteren Ausführungsform einer erfindungsgemäßen Laseranordnung in einer Draufsicht;
- Fig. 5: eine schematische Darstellung einer Ausführungsform gemäß Fig. 4 einer erfindungsgemäßen Laseranordnung in einer seitlichen Ansicht;
- Fig. 6: eine perspektivische Ansicht einer Ausführungsform gemäß Fig. 4 mit einem Reflektionselement;
- Fig. 7: eine rein schematische und nicht auf wirkliche Verhältnisse gerichtete Darstellung zur Illustration der Ausbildung des linienförmigen Arbeitsbereiches durch sich überlappende Laserlichteinfallkegel nach Durchtritt durch die Linseneinrichtung;
- Fig. 8: eine perspektivische Ansicht einer weiteren Ausführungsform einer erfindungsgemäßen Laseranordnung;
- Fig. 9: eine schematische Seitenansicht einer weiteren Ausführungsform einer erfindungsgemäßen Laseranordnung.

Zunächst wird auf Fig. 1 Bezug genommen.

Die Fig. 1 zeigt eine Laseranordnung gemäß dem Stand der Technik. Eine Mehrzahl von Laserlichtquellen 1 ist jeweils in einer Reihe angeordnet und deren Laserlichtaustritt in Richtung eines Werkstücks 6 ausgerichtet. Durch diese Anordnung wird ein linienförmiger Arbeitsbereich 5 auf dem Werkstück erzeugt, der wegen der jeweiligen Überschneidungen der angedeuteten Laserstrahlkegel durch unterschiedliche Energiedichten, jedenfalls aber durch geringe Energiedichten in den Randbereichen gekennzeichnet ist.

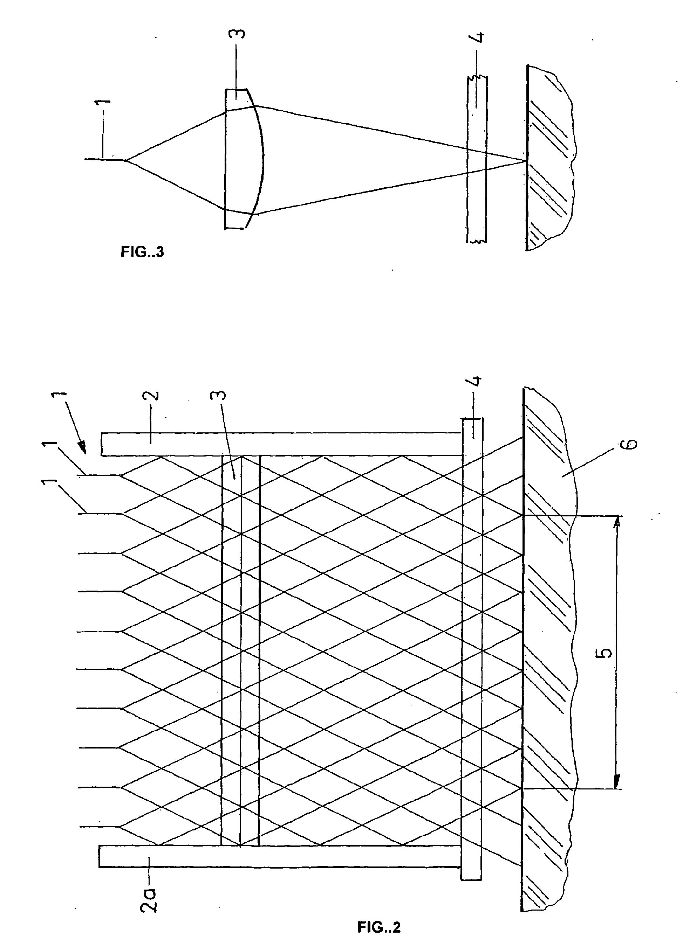

In Fig. 2 und Fig. 3 ist nunmehr eine erfindungsgemäße Laseranordnung dargestellt. Die erfindungsgemäße Laseranordnung zeichnet sich zunächst dadurch aus, dass zwei flächige Reflektionselemente 2, 2a, insbesondere flächige Spiegel, zumindest abschnittsweise seitlich der Laserlichtquellen 1 und des Werkstücks 2 vorgesehen sind. Die Reflexionselemente 2, 2a sind dazu geeignet einen Teil des Laserlichts in einen vorbestimmbaren Arbeitsbereich 5 zu reflektieren. Hierdurch kann das Laserlicht der randseitig vorgesehenen Laserlichtquellen 1 ebenfalls für den vorbestimmten Arbeitsbereich 5 nutzbar gemacht werden.

Hieraus ergibt sich eine bessere Ausnutzung des von den Laserlichtquellen 1 bereitgestellten Laserlichtes, da der ursprünglich nicht nutzbare Teil in den vorbestimmten Arbeitsbereich reflektiert werden kann. Dementsprechend wird der Wirkungsgrad einer erfinderisch ausgestalteten Laseranordnung erhöht bzw. es werden weniger Laserlichtquellen 1 benötigt um einen, vergleichbar dem Stand der Technik, gleichen Arbeitsbereich 5 mit der gleichen vorbestimmbaren Energie auszuleuchten.

Ein weiterer vorteilhafter Effekt der Anordnung von Reflexionselementen 2, 2a in der vorgeschlagenen Weise ist, dass die Homogenität der Energieverteilung über den Arbeitsbereich 5 verbessert werden kann. Ausgehend von sich überschneidenden Laserlichtkegeln, wie beispielsweise in Fig. 1 angedeutet, ergeben sich Bereiche hoher Energieeinstrahlung neben Bereichen geringer oder geringster Energieeinstrahlung. Das Maß der Energieeinstrahlung ist unter anderem davon abhängig, wie viele Laserlichtquellen 1 einen bestimmten Abschnitt des Arbeitsbereiches 5 ausleuchten. Durch entsprechende Reflexion bzw. Umlenkung der Laserstrahlen können gezielt Bereiche mit niedriger bzw. niedrigster Laserlichteinstrahlung zusätzlich ausgeleuchtet werden, so dass eine weitgehend homogene Energieverteilung entlang des Arbeitsbereiches sichergestellt werden kann.

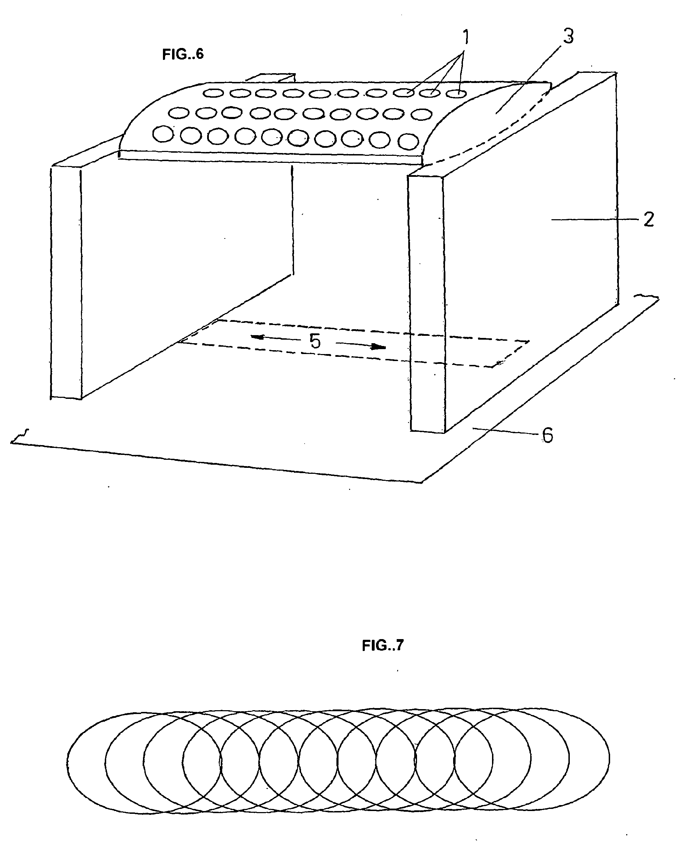

Des Weiteren ist vorgesehen, dass mindestens eine Zylinderlinse 3 zwischen den Laserlichtquellen 1 und dem Werkstück 6 bzw. Arbeitsbereich 5 angeordnet ist. Die Zylinderlinse 3 trägt ebenfalls zu einer Homogenisierung der Energieverteilung entlang des Arbeitsbereiches 5 und zur vorteilhaften Ausformung des Arbeitsbereiches 5 bei. Ausgehend von einer im Wesentlichen kreisförmigen Gestalt des jeweils auftreffenden Laserlichtkegels, ergibt sich ohne die Zylinderlinse 3 eine Abfolge von sich überschneidenden kreisförmigen Laserlichtkegeln, die den Arbeitsbereich 5 ausbilden. Wird nunmehr wie vorgeschlagen, eine Zylinderlinse 3 in den Strahlengang eingefügt, wird der ursprünglich divergierende Laserstrahl in einer Richtung kollimiert oder fokussiert, in der dazu senkrechten Richtung jedoch nicht beeinflusst, so dass der Arbeitsbereich 5 nunmehr durch eine Abfolge von stark elliptisch ausgeformten auftreffenden Lichtkegeln gekennzeichnet ist (vgl. rein beispielhaft und schematisch dargestellt in Fig. 7). Dementsprechend ergeben sich weitreichende Überlappungsbereiche, die eine annährend homogene Energieverteilung über den Arbeitsbereich 5 zur Folge haben.

Besonders gute Ergebnisse ergeben sich bei einem Abstand von etwa 50 cm zwischen der Zylinderlinse und dem Werkstück 6.

Auch ist vorteilhafterweise eine für das Laserlicht durchlässige Platte 4 zwischen den Reflexionselementen 2, 2a und dem Werkstück 6 vorgesehen.

Auch ist vorteilhafterweise vorgesehen, dass es sich bei den Laserlichtquellen 1-µm-Lichtleitfasern handelt, die entsprechend mit einem geeigneten Laser beaufschlagt sind. Selbstverständlich kann auch vorgesehen sein, die Laser direkt an den angedeuteten Einstrahlpositionen (Laserlichtquelle 1) anzubringen, jedoch ergeben sich hierdurch unnötige Beschränkungen des Abstandes der Laserlichtquellen 1 zueinander, der vorzugsweise 1 cm betragen sollte. Auch ergeben sich durch die Verwendung von Lichtleitfasern in etwa kreisförmige Laserstrahlen, im Gegensatz von direkt aus dem Laser austretende Laserstrahlen, die beispielsweise einen vornehmlich quadratischen Querschnitt aufweisen. Eine Laserstrahl mit einem kreisförmigen Querschnitt bzw. mit einem elliptischen Querschnitt (nach der Zylinderlinse 3) erzeugt jedoch weitaus weichere Übergangsbereiche hinsichtlich der Energieverteilung als es beispielsweise bei Laserstrahlen mit einem rechteckigen Querschnitt (nach der Zylinderlinse 3) der Fall wäre.

Derzeit werden Laserlichtquellen 1 mit einer Laserlichtleistung von etwa 100 W eingesetzt. Es ist vorgesehen, dass etwa 100 Laserlichtquellen 1 in einer Laserlichtanordnung zusammengefasst werden, so dass sich eine Lichtleistung in dem Arbeitsbereich 5 von etwa 10 kW ergibt. Denkbar sind jedoch Lichtleistungen von 1 Megawatt, die sich vorzugsweise durch einzelne Laserlichtquellen 1 von etwa 400 Watt erreichen lassen und einer Anordnung der Laserlichtquellen 1 bzw. der Zylinderlinse 3 wie schematisch in der Fig. 6 dargestellt.

Dabei ist die Zylinderlinse 3 wie eine Kuppel oberhalb des Werkstücks 6 bzw. des Arbeitsbereiches 5 angeordnet. Die angedeuteten Kreise stellen jeweils Einstrahlungspunkte für die Laserlichtquellen 1 dar. Die Anordnung bzw. Ausrichtung der Laserlichtquellen 1 bzw. der Zylinderlinse 3 ist jeweils so gewählt, dass die Laserstrahlen den linienförmigen Arbeitsbereich 5 ausbilden, der in der oben vorgeschlagenen Weise optimiert bzw. homogenisiert ist. Alternativ kann auch eine Anordnung mehrerer Zylinderlinsen 3, 3a, 3b vorgesehen sein.

Insgesamt lässt sich eine Laseranordnung gemäß dem Stand der Technik mit den hier vorgeschlagenen Maßnahmen deutlich verbessern, sowohl hinsichtlich der Homogenisierung der Energieverteilung im Arbeitsbereich 5, als auch in der Effizienz der Energieeinstrahlung in den Arbeitsbereich 5. Wie bereits angedeutet lässt sich auch die Anzahl der Laserlichtquellen 1 bei gleichbleibender Lichtleistung im Arbeitsbereich reduzieren, da das Laserlicht wesentlich effektiver ausgenutzt wird, indem auch das Laserlicht der äußeren Laserlichtquellen 1 in den Arbeitsbereich umgelenkt wird. Im Umkehrschluss kann mit der gleichen Anzahl von Laserlichtquellen 1 auch eine wesentlich höhere Lichtleistung in den Arbeitsbereich eingebracht werden, wodurch derart hohe Leistungen von 1 Megawatt im Arbeitsbereich 5 auf rationale Art und Weise möglich sind.

Auch bietet eine derartige Laseranordnung eine hohe Ausfallsicherheit. Für den Fall, dass eine Laserlichtquelle ausfallen sollte, hat dies nur einen Leistungsverlust von 0,01 % zur Folge, wohingegen der Ausfall einer Laserlichtquelle in einer Anordnung gemäß dem Stand der Technik bereits 1 % Leistungsverlust bedeutet.

Eine hier vorgeschlagene Laseranordnung kann beispielsweise zur Trocknung einer Werkstückbahn oder auch für die Aufschmelzung von Werkstückoberflächen vorgesehen sein. Dementsprechend kann auch vorgesehen sein, dass das Werkstück 6 und die Laseranordnung jeweils relativ zueinander bewegt werden.

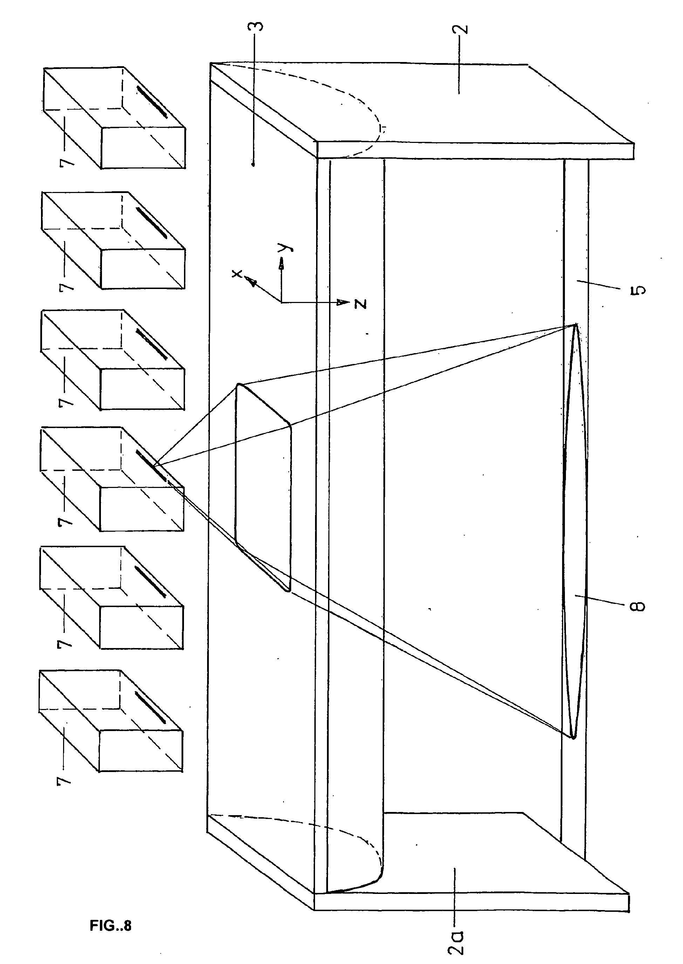

Aus Fig. 8 ist eine erfindungsgemäße Anordnung ersichtlich, bei der als Laserlichtquellen 7 Laserdiodenbarren vorgesehen sind. Diese sind so angeordnet, dass sie in Richtung ihrer Fast-Axis (y in Fig. 8), d.h. in Richtung senkrecht zur Schichtstruktur des Halbleiterlasers, beabstandet nebeneinander angeordnet sind.

Die Slow-Axis-Richtung (x in Fig. 8) der Laserstrahlung wird durch die Zylinderlinse 3 kollimiert, wohingegen die Fast-Axis-Richtung bei Ausbreitung der Laserstrahlung in z-Richtung (siehe Fig. 8) weiter divergiert, so dass in dem linienförmigen Arbeitsbereich 5 von jeder Laserlichtquelle 7 ein in y-Richtung relativ ausgedehnter Bereich 8 ausgeleuchtet wird.

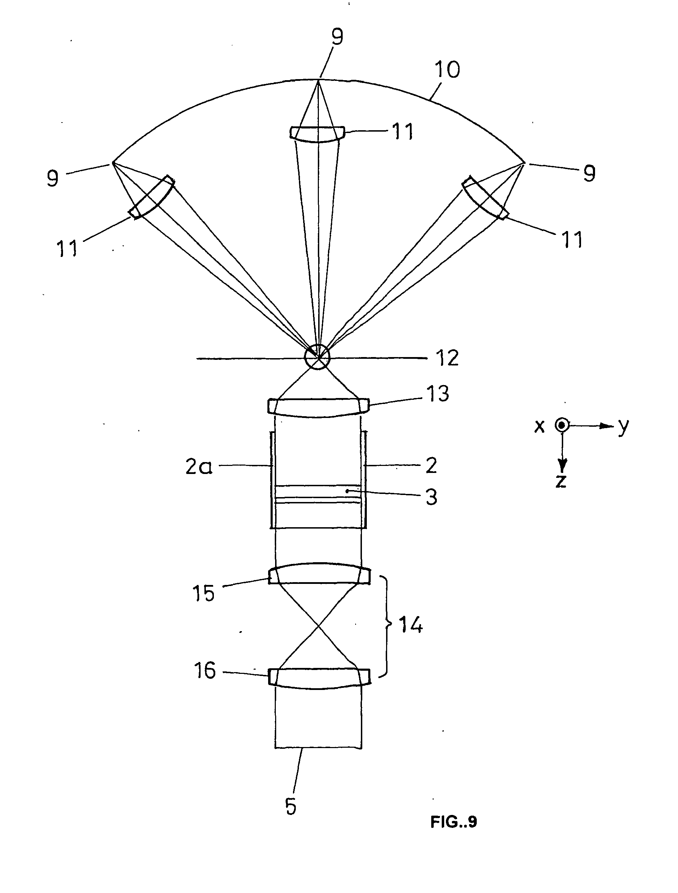

Fig. 9 zeigt eine Ausführungsform einer erfindungsgemäßen Anordnung, bei der als Faserenden oder Laserdiodenbarren oder dergleichen ausgeführte Laserlichtquellen 9 auf einem Kreisbogen 10 angeordnet sind. Jeder der Laserlichtquellen 9 sind Fokussiermittel 11 zugeordnet, die die von den einzelnen Laserlichtquellen 9 ausgehende Laserstrahlung in einen gemeinsamen Fokusbereich, insbesondere einen etwa punktförmigen Fokusbereich fokussieren. Der Mittelpunkt 12 des Kreisbogens 10 ist dabei in dem gemeinsamen Fokusbereich angeordnet. Je mehr Laserlichtquellen 9 verwendet werden sollen, desto größer muss der Kreisbogen 10 sein, was durch Vergrößerung des Radius des Kreisbogens erreicht werden kann.

Hinter dem gemeinsamen Fokusbereich, bzw. hinter dem Mittelpunkt 12 des Kreisbogens 10 ist in mittlerer Ausbreitungsrichtung z (siehe Fig. 9) der Laserstrahlung eine Zylinderlinse 13 angeordnet, die die von den einzelnen Laserlichtquellen 9 ausgehende Laserstrahlung hinsichtlich der Y-Richtung (siehe Fig. 9) weitgehend kollimiert, so dass sich die Laserstrahlung zwischen den beiden Reflexionselementen 2, 2a in z-Richtung ausbreiten kann. Dabei erstreckt sich die Zylinderachse der Zylinderlinse 13 in x-Richtung. Die Zylinderachse der Zylinderlinse 3 erstreckt sich in y-Richtung.

Anstelle der Anordnung des Werkstückes 6 in unmittelbarer Nähe zu den Reflexionselementen 2, 2a ist bei der in Fig. 9 abgebildeten Anordnung das Werkstück bzw. der linienförmige Arbeitsbereich 5 weiter von den Reflexionselementen 2, 2a entfernt. Dies wird durch Einfügung einer Abbildungsoptik 14 erzielt. Diese Abbildungsoptik 14 kann aus Zylinderlinsen 15, 16 bestehen und eine 1:1- oder 1:-1-Abbildung der Laserstrahlung in die Arbeitsebene bewirken.

## Patentansprüche

1. Laseranordnung zur Bearbeitung eines Werkstückes (6), umfassend eine Mehrzahl von Laserlichtquellen (1) zur Einbringung einer Laserstrahlung in einen vorbestimmbaren Arbeitsbereich (5), wobei mindestens ein Reflektionselement (2, 2a) vorgesehen ist, welches dazu geeignet ist, einen Teil der Laserstrahlung in den Arbeitsbereich (5) umzulenken, wobei eine Mehrzahl von Laserlichtquellen (1) in mindestens einer Reihe angeordnet sind, und wobei die Laserlichtquellen (1) einen linienförmigen Arbeitsbereich (5) ausbilden können, **dadurch gekennzeichnet, dass** das mindestens eine Reflektionselement (2, 2a) dazu geeignet ist, die von den äußeren Laserlichtquellen ausgehende Laserstrahlung in den Arbeitsbereich (5) zu reflektierten, dass das mindestens eine Reflektionselement (2, 2a) flächig ausgestaltet ist und dass die Reihe der Laserlichtquellen (1) in etwa orthogonal zu dem mindestens einen Reflektionselement (2, 2a) ausgerichtet ist.

2. Laseranordnung nach Anspruch 1, **dadurch gekennzeichnet, dass** ein erstes Reflektionselement (2) und ein zweites Reflektionselement (2a) vorgesehen ist, wobei sich die Reflektionselemente (2, 2a) in etwa zwischen den Laserlichtquellen (1) und dem Werkstück (6) erstrecken.

3. Laseranordnung nach einem der Ansprüche 1 oder 2, **dadurch gekennzeichnet, dass** eine Linseneinrichtung zwischen den Laserlichtquellen (1) und dem Werkstück (6) angeordnet ist, die zur Kollimation oder Fokussierung der von den Laserlichtquellen (1) ausgesandten Laserstrahlen hinsichtlich einer Richtung, insbesondere hinsichtlich einer Richtung senkrecht zur mittleren Ausbreitungsrichtung der Laserstrahlen, geeignet ist.

4. Laseranordnung nach Anspruch 3, **dadurch gekennzeichnet, dass** es sich bei der Linseneinrichtung um mindestens eine Zylinderlinse (3) handelt.

5. Laseranordnung nach einem der Ansprüche 3 oder 4, **dadurch gekennzeichnet, dass** es sich bei der Linseneinrichtung um eine Mehrzahl von Zylinderlinsen (3, 3a, 3b) handelt, die vorzugsweise einen Winkel ungleich 0° und ungleich 180°, insbesondere einen Winkel zwischen 140° und 160°, miteinander einschließen.

6. Laseranordnung nach einem der Ansprüche 3 bis 5, **dadurch gekennzeichnet, dass** der Abstand zwischen der Linseneinrichtung (3) und dem Werkstück (6) in etwa 50 cm beträgt.

7. Laseranordnung nach einem der Ansprüche 1 bis 6, **dadurch gekennzeichnet, dass** einige oder sämtliche der Laserlichtquellen (9) auf einem Kreisbogen (10) angeordnet sind.

8. Laseranordnung nach Anspruch 7, **dadurch gekennzeichnet, dass** die von den auf dem Kreisbogen (10) angeordneten Laserlichtquellen (9) ausgehende Laserstrahlung zumindest teilweise in einen Fokusbereich, der insbesondere im Wesentlichen punktförmig ist, fokussiert wird.

9. Laseranordnung nach Anspruch 8, **dadurch gekennzeichnet, dass** der Kreisbogen (10) um einen Mittelpunkt (12) angeordnet ist, der im Wesentlichen dem, insbesondere punktförmigen, Fokusbereich entspricht.

10. Laseranordnung nach einem der Ansprüche 1 bis 9, **dadurch gekennzeichnet, dass** es sich bei der Laserlichtquelle (1) um einen Halbleiterlaser (9) oder um eine Lichtleitfaser handelt, die vorzugsweise von mindestens einem Halbleiterlaser gespeist wird.

11. Laseranordnung nach einem der Ansprüche 3 bis 10, **dadurch gekennzeichnet, dass** eine zumindest teilweise lichtdurchlässige Platte (4) zwischen der Linseneinrichtung (3) und dem Werkstück (6) vorgesehen ist.

12. Laseranordnung nach einem der Ansprüche 1 bis 11, **dadurch gekennzeichnet, dass** die Laserlichtquellen (1) in parallelen Reihen angeordnet sind.

13. Laseranordnung nach einem der Ansprüche 4 bis 12, **dadurch gekennzeichnet, dass** die Laserstrahlung hinter dem Fokusbereich, in den die von den auf dem Kreisbogen (10) angeordneten Laserlichtquellen (9) ausgehende Laserstrahlung fokussiert wird, auf die Zylinderlinse (3) oder die Mehrzahl von Zylinderlinsen (3, 3a, 3b) trifft.

14. Laseranordnung nach Anspruch 13, **dadurch gekennzeichnet, dass** zwischen dem Fokusbereich und der Zylinderlinse (3) oder der Mehrzahl von Zylinderlinsen (3, 3a, 3b) eine weitere Linse, insbesondere eine weitere Zylinderlinse (13) vorgesehen ist.

15. Laseranordnung nach einem der Ansprüche 1 bis 14, **dadurch gekennzeichnet, dass** in Ausbreitungsrichtung der Laserstrahlung hinter den Reflexionselementen (2, 2a) eine Abbildungsoptik (14) zur Abbildung der Laserstrahlung auf das Werkstück vorgesehen ist.

## Claims

1. Laser arrangement for machining a workpiece (6), comprising a plurality of laser light sources (1) for introducing a laser radiation into a predeterminable working area (5), wherein there is at least one reflection element (2, 2a), which is suitable for deflecting part of the laser radiation into the working area (5), wherein a plurality of laser light sources (1) are arranged in at least one row, and wherein the laser light sources (1) can form a linear working area (5), **characterized in that** the at least one reflection element (2, 2a) is suitable for reflecting the laser radiation emanating from the outer laser light sources into the working area (5), **in that** the at least one reflection element (2, 2a) is of a two-dimensional configuration, and **in that** the row of laser light sources (1) is aligned approximately orthogonal to the at least one reflection element (2, 2a).

2. Laser arrangement according to Claim 1, **characterized in that** there is a first reflection element (2) and a second reflection element (2a), wherein the reflection elements (2, 2a) extend approximately between the laser light sources (1) and the workpiece (6).

3. Laser arrangement according to either of Claims 1 and 2, **characterized in that** a lens device which is suitable for the collimation or focusing of the laser beams emitted by the laser light sources (1) with regard to one direction, in particular with regard to a direction perpendicular to the average direction of propagation of the laser beams, is arranged between the laser light sources (1) and the workpiece (6).

4. Laser arrangement according to Claim 3, **characterized in that** the lens device comprises at least one cylindrical lens (3).

5. Laser arrangement according to either of Claims 3 and 4, **characterized in that** the lens device comprises a plurality of cylindrical lenses (3, 3a, 3b), which preferably form with one another an included angle unequal to 0° and unequal to 180°, in particular an angle between 140° and 160°.

6. Laser arrangement according to one of Claims 3 to 5, **characterized in that** the distance between the lens device (3) and the workpiece (6) is approximately 50 cm.

7. Laser arrangement according to one of Claims 1 to 6, **characterized in that** some or all of the laser light sources (9) are arranged on an arc (10) of a circle.

8. Laser arrangement according to Claim 7, **characterized in that** the laser radiation emanating from the laser light sources (9) arranged on the arc (10) is at least partially focused into a focal area that is, in particular, substantially puntiform.

9. Laser arrangement according to Claim 8, **characterized in that** the arc (10) is arranged around a center point (12), which corresponds substantially to the, in particular puntiform, focal area.

10. Laser arrangement according to one of Claims 1 to 9, **characterized in that** the laser light source (1) comprises a semiconductor laser (9) or an optical fiber which is preferably fed by at least one semiconductor laser.

11. Laser arrangement according to one of Claims 3 to 10, **characterized in that** an at least partially laser-light-transmitting plate (4) is provided between the lens device (3) and the workpiece (6).

12. Laser arrangement according to one of Claims 1 to 11, **characterized in that** the laser light sources (1) are arranged in parallel rows.

13. Laser arrangement according to one of Claims 4 to 12, **characterized in that** the laser radiation impinges on the cylindrical lens (3) or the plurality of cylindrical lenses (3, 3a, 3b) downstream of the focal area into which the laser radiation emanating from the laser light sources (9) arranged on the arc (10) is focused.

14. Laser arrangement according to Claim 13, **characterized in that** a further lens, in particular a further cylindrical lens (13) is provided between the focal area and the cylindrical lens (3) or the plurality of cylindrical lenses (3, 3a, 3b).

15. Laser arrangement according to one of Claims 1 to 14, **characterized in that** imaging optics (14) for imaging the laser radiation onto the workpiece are provided downstream of the reflection elements (2, 2a) in the direction of propagation of the laser radiation.

## Revendications

1. Arrangement laser pour traiter une pièce (6), comprenant une pluralité de sources de lumière laser (1) pour faire pénétrer une rayon laser dans une zone de travail prédéfinie (5), au moins un élément réflecteur (2, 2a) étant prévu, lequel est conçu pour dévier une partie du rayon laser dans la zone de travail (5), une pluralité de sources de lumière laser (1) étant disposées en au moins une rangée et les sources de lumière laser (1) pouvant former une zone de travail (5) rectiligne, **caractérisé en ce que** l'au moins un élément réflecteur (2, 2a) est conçu pour réfléchir dans la zone de travail (5) le rayon laser émanant des sources de lumière laser les plus à l'extérieur, que l'au moins un élément réflecteur (2, 2a) est de forme plate et que la rangée de sources de lumière laser (1) est orientée de manière approximativement orthogonale par rapport à l'au moins un élément réflecteur (2, 2a).

2. Arrangement laser selon la revendication 1, **caractérisé en ce qu'**un premier élément réflecteur (2) et un deuxième élément réflecteur (2a) sont prévus, les éléments réflecteurs (2, 2a) s'étendant approximativement entre les sources de lumière laser (1) et la pièce (6).

3. Arrangement laser selon l'une des revendications 1 ou 2, **caractérisé en ce qu'**un dispositif à lentilles est disposé entre les sources de lumière laser (1) et la pièce (6), lequel est conçu pour la collimation ou la concentration des rayons laser émis par les sources de lumière laser (1) du point de vue d'une direction, notamment du point de vue d'une direction perpendiculaire au sens de propagation moyen des rayons laser.

4. Arrangement laser selon la revendication 3, **caractérisé en ce que** le dispositif à lentilles est au moins une lentille cylindrique (3).

5. Arrangement laser selon l'une des revendications 3 ou 4, **caractérisé en ce que** le dispositif à lentilles est une pluralité de lentilles cylindriques (3, 3a, 3b) qui forment entre elles un angle de préférence différent de 0° et différent de 180°, notamment un angle compris entre 140° et 160°.

6. Arrangement laser selon l'une des revendications 3 à 5, **caractérisé en ce que** l'écart entre l'arrangement de lentilles (3) et la pièce (6) est d'environ 50 cm.

7. Arrangement laser selon l'une des revendications 1 à 6, **caractérisé en ce que** certaines ou la totalité des sources de lumière laser (9) sont disposées sur un arc de cercle (10).

8. Arrangement laser selon la revendication 7, **caractérisé en ce que** le rayonnement laser émanant des sources de lumière laser (9) disposées sur l'arc de cercle (10) est au moins partiellement concentré dans une zone de concentration qui est notamment pour l'essentiel ponctuelle.

9. Arrangement laser selon la revendication 8, **caractérisé en ce que** l'arc de cercle (10) est disposé autour d'un point central (12) qui correspond pour l'essentiel à la zone de concentration notamment ponctuelle.

10. Arrangement laser selon l'une des revendications 1 à 9, **caractérisé en ce que** la source de lumière laser (1) est un laser semiconducteur (9) ou une fibre optique qui est alimentée de préférence par au moins un laser semiconducteur.

11. Arrangement laser selon l'une des revendications 3 à 10, **caractérisé en ce qu'**il est prévu une plaque (4) au moins partiellement transparente à la lumière entre l'arrangement de lentilles (3) et la pièce (6).

12. Arrangement laser selon l'une des revendications 1 à 11, **caractérisé en ce que** les sources de lumière laser (1) sont disposées en rangées parallèles.

13. Arrangement laser selon l'une des revendications 4 à 12, **caractérisé en ce que** le rayon laser, derrière la zone de concentration dans laquelle est concentré le rayon laser émanant des sources de lumière laser (9) disposées sur l'arc de cercle (10), vient frapper la lentille cylindrique (3) ou la pluralité de lentilles cylindriques (3, 3a, 3b).

14. Arrangement laser selon la revendication 13, **caractérisé en ce qu'**une lentille supplémentaire, notamment une lentille cylindrique supplémentaire (13) est prévue entre la zone de concentration et la lentille cylindrique (3) ou la pluralité de lentilles cylindriques (3, 3a, 3b).

15. Arrangement laser selon l'une des revendications 1 à 14, **caractérisé en ce qu'**une optique de image (14) destinée à représenter le rayon laser sur la pièce est prévue derrière les éléments réflecteurs (2, 2a) dans le sens de propagation du rayon laser.
